# EUROPÄISCHE PATENTSCHRIFT

(11) **EP 2 513 554 B1**
(45) Veröffentlichungstag und Bekanntmachung des Hinweises auf die Patenterteilung: **06.04.2016**
(21) Anmeldenummer: 10800727.9
(22) Anmeldetag: 17.12.2010
(51) Int. Cl.: F21K 99/00, H05K 1/02, H05K 1/18, F21Y 115/10, F21Y 105/00

(54) **LEUCHTMITTEL MIT EINER MEHRZAHL VON LEUCHTDIODEN**
LAMP HAVING A PLURALITY OF LIGHT-EMITTING DIODES
MOYEN D'ÉCLAIRAGE COMPORTANT PLUSIEURS DIODES D'ÉCLAIRAGE

(30) Priorität: 17.12.2009 DE 102009054840
(43) Veröffentlichungstag der Anmeldung: 24.10.2012
(73) Patentinhaber: Poly-Licht GmbH, 67663 Kaiserslautern (DE)
(72) Erfinder: STAUCH, Stefan, 67655 Kaiserslautern (DE); WERZ, Frank, 67659 Kaiserslautern (DE)
(74) Vertreter: WSL Patentanwälte Partnerschaft mbB
(86) Internationale Anmeldenummer: PCT/EP2010/070110
(87) Internationale Veröffentlichungsnummer: WO 2011/080125

(56) Entgegenhaltungen:
- EP-A1- 1 767 849
- WO-A1-02/052524
- WO-A1-2005/001943
- DE-A1- 19 922 176
- DE-A1-102004 009 284
- DE-A1-102004 016 847
- DE-A1-102005 005 896
- DE-A1-102007 044 446
- DE-A1-102007 047 717
- DE-A1-102008 038 857
- DE-A1-102008 052 869
- DE-T5-112006 003 139
- US-A1- 2002 001 193
- US-A1- 2002 047 516
- US-A1- 2006 290 620
- US-A1- 2007 007 540
- US-A1- 2009 236 621

## Beschreibung

Die vorliegende Erfindung betrifft ein Leuchtmittel mit einer Mehrzahl von Leuchtdioden.

Ein solches Leuchtmittel kann in einer Vielzahl von Leuchten, beispielsweise für den Industrie- oder Heimbereich, und insbesondere in Straßenleuchten eingesetzt werden.

In einem weiteren Aspekt betrifft die Erfindung auch die Herstellung eines solchen Leuchtmittels.

In der Beleuchtungstechnik werden heute noch immer viele Glühlampen sowie Leuchtstoffröhren als Leuchtmittel eingesetzt. Zunehmend findet auch der Einsatz von Leuchtdioden Verbreitung. Leuchtmittel mit Leuchtdioden sind dementsprechend im Stand der Technik bekannt. Zu ihrer Herstellung werden Standard-Platinen eingesetzt, die mit Leuchtdioden bestückt und dann in ein Gehäuse einer Leuchte eingebaut werden. Dies ist jedoch ohne Weiteres nur bei Leuchten möglich, bei denen die Leuchtdioden in einer Ebene angeordnet sind. Daher muss für die Bestückung einer Leuchte mit Leuchtdioden in nicht ebener Anordnung ein erhöhter Aufwand getrieben werden, indem ein spezieller Leuchtdiodenträger für die gewünschte Anordnung der Leuchtdioden hergestellt und dieser anschließend bestückt wird. Da die Bestückung durch die dreidimensionale Anordnung der Leuchtdioden ein aufwendiger Vorgang ist, kann dieser nur in Handarbeit oder mit aufwendiger Automatisierung durchgeführt werden.

Die EP 1 767 849 A1 offenbart eine Leuchteinrichtung mit einem Lichtleitelement sowie dem Lichtleitelement zugeordneten Lichterzeugungsmitteln. Die Leuchteinrichtung gemäß der EP 1 767 849 A1 zeichnet sich dadurch aus, dass die Lichterzeugungsmittel eine Mehrzahl von Lichterzeugungselementen mit jeweils einer Lichtquelle umfassen und das Lichtleitelement eine Mehrzahl von konkaven Vertiefungen aufweist, in welchen jeweils eine Lichtquelle eines Lichterzeugungselementes angeordnet ist.

Aus der DE 10 2007 044 446 A1 ist zudem ein flexibler Schaltkreis bekannt, der montierte elektrische Komponenten, wobei Bonddrähte, die eine elektrische Verbindung zu den elektrischen Komponenten bereitstellen, senkrecht zu der primären Ebene ausgerichtet sind, in die sich der flexible Schaltkreis biegt, und mehrere redundante Via für elektrische und thermale Verbindungen aufweist. Der flexible Schaltkreis kann ein Array aus Leuchtdioden (LEDs) aufweisen, die längs in einem flexiblen LED-Streifen angeordnet sind, sowie flexible gedruckte Schaltkreise, an denen eine Mehrzahl an elektrischen Komponenten befestigt sind, wobei die elektrischen Komponenten LEDs aufweisen können.

Aufgabe der vorliegenden Erfindung ist es gegenüber diesem Stand der Technik, ein Leuchtmittel mit Leuchtdioden bereitzustellen, welches weißes Licht abstrahlen kann und das flexibel ist.

Erfindungsgemäß wird diese Aufgabe gelöst durch ein Leuchtmittel mit einer Mehrzahl von Leuchtdioden, die jeweils elektrische Anschlüsse aufweisen, und mit einer flexiblen Trägerfolie mit mindestens einer elektrisch isolierenden Oberfläche, wobei die Leuchtdioden auf die Trägerfolie aufgebracht sind, wobei auf der elektrisch isolierenden Oberfläche der Trägerfolie mindestens eine elektrische Leiterbahn angeordnet ist und wobei ein elektrischer Anschluss der Leuchtdioden elektrisch leitend mit der Leiterbahn verbunden ist, wobei auf eine Oberfläche der Trägerfolie zumindest abschnittsweise ein Verbundmaterial aufgebracht ist, das es zumindest eine der Leuchtdioden überdeckt, wobei das Verbundmaterial ein Luminophormaterial aufweist und wobei das Verbundmaterial flexibel ist, sodass es zusammen mit der Trägerfolie verformbar ist.

Unter dem Begriff Trägerfolie wird neben einer klassischen Kunststofffolie auch ein Blech, ein Karton, dünne Kunststoffplatten oder ein ähnliches, im Vergleich zu seiner Längs- und Querausdehnung dünnes sowie flexibles, wenigstens jedoch plastisch in seiner Form ohne Zerstörung erheblich verformbares Stück Material verstanden.

Die Trägerfolie kann auch ein Verbund aus mehreren einzelnen Folien oder Blechen sein. In einer Ausführungsform ist die Oberfläche einer metallischen Trägerfolie ist elektrisch isoliert, z.B. durch eine elektrochemische Passivierung, eine Lackierung, eine Kaschierung, z.B. mit einer elektrisch nichtleitenden Folie, oder durch eine Beschichtung.

Das Material der Trägerfolie ist einer Ausführungsform der Erfindung beispielsweise Polyethylen (PE), Polyethylenterephthalat (PET), Polyethylennaphthalat (PEN), Polyimid (PI) oder ein anderer Kunststoff, wobei das Material vorteilhaft, jedoch nicht zwingend, für erhöhte Temperaturen geeignet ist.

Flexibilität bedeutet im Sinne der vorliegenden Anmeldung, dass die Trägerfolie elastisch oder plastisch von einer ebenen Form in eine gewünschte, von der ebenen Form abweichende Form gebracht werden kann, ohne wesentliche Beeinträchtigungen der Trägerfolie, beispielsweise Brüche, auftreten.

Ein Vorteil eines solchen Leuchtmittels ist, dass die verformbare Trägerfolie in ebener Form mit einem Bestückungsautomaten einfach und kostengünstig mit Leuchtdioden oder auch mit anderen, zusätzlichen Bauteilen bestückt werden kann, und eine so bestückte Trägerfolie beim An- oder Einbau als Leuchtmittel in eine Leuchte, beispielsweise in eine Mastansatzleuchte, in einen Industriestrahler oder in eine Leuchte im Heimbereich, eine Vielzahl von Leuchtdioden in einem Arbeitsschritt mit der Leuchte verbindet. Dabei ermöglicht die Flexibilität der Trägerfolie insbesondere, dass die Anordnung der Leuchtdioden auf einfache Weise an die gewünschte Geometrie für das Leuchtmittel angepasst werden kann, indem die Trägerfolie verformt wird. Auf diese Weise können die Leuchtdioden so ausgerichtet werden, dass eine gewünschte Abstrahlcharakteristik entsteht.

In einer weiteren Ausführungsform der Erfindung ist die Trägerfolie auf ein Wärmeableitelement aufgebracht, das Wärme von den Leuchtdioden abführt.

Da bei der Bestückung mit Hochleistungsleuchtdioden oder bei einer hohen Bestückungsdichte viel Abwärme pro Fläche der Trägerfolie erzeugt wird, ist eine gute Wärmeableitung zur Vermeidung von Überhitzung der Leuchtdioden erforderlich. Das Wärmeableitelement ist daher dazu geeignet, die Wärme von den Leuchtdioden durch die Trägerfolie hindurch aufzunehmen und abzuleiten. Dazu weist das Wärmeableitelement vorteilhaft eine gute Wärmeleitfähigkeit auf. Besonders geeignet sind Metalle wie Kupfer oder Aluminium oder deren Legierungen. Alternativ kann die Wärmeableitung auch durch Konvektion eines Mediums bewirkt werden, das sich im Inneren eines hohlen Wärmeableitelements befindet, beispielsweise durch Ausgestaltung als Wärmerohr. Vorteilhaft kann auf das Wärmeableitelement oder auf die Trägerfolie eine Klebstoffschicht aufgebracht sein, so dass die Trägerfolie ohne Aufwand auf das Wärmeableitelement aufgeklebt werden kann.

In einer weiteren Ausführungsform ist auf die Seite der Trägerfolie, die den Leuchtdioden gegenüberliegt, eine Wärmeleitpaste, ein Wärmeleitlack oder eine Wärmeleitfolie aufgebracht.

Dadurch wird der Wärmeübergang von der Trägerfolie zu einem Trägerelement, auf dem diese aufgebracht ist, verbessert. Insbesondere gleicht die Wärmeleitpaste, der Wärmeleitlack oder eine Wärmeleitfolie dabei Unebenheiten in der Oberfläche des Trägerelements aus, auf das die Trägerfolie aufgebracht ist und ersetzt dabei vorteilhaft Luft zwischen der Trägerfolie und dem Trägerelement.

Wärmeleitfolien, eine flächig ausgedehnte Form von sogenannten Wärmeleitpads, beispielsweise auf Basis von Silikongummi oder Kapton, haben den Vorteil, dass sie einfach mit der Trägerfolie verbindbar und kommerziell erhältlich sind. Wärmeleitfolien im Sinne der vorliegenden Erfindung weisen eine ähnliche Flexibilität auf wie die Trägerfolie.

In einer zweckmäßigen Ausführungsform ist auf einer Wärmeleitfolie eine Klebstoffschicht aufgebracht, mit der die Trägerfolie auf ein Trägerelement, insbesondere ein Wärmeableitelement aufklebbar ist. Weiterhin ist es vorteilhaft, wenn die Wärmeleitfolie eine Klebstoffschicht aufweist, mit der sie auf die Trägerfolie aufklebbar ist.

In einer besonders bevorzugten Ausführungsform weist das erfindungsgemäße Leuchtmittel also eine Mehrschichtige Struktur mit folgenden Schichten auf: Leuchtdioden, Trägerfolie, Leiterbahn(en), Wärmeleitfolie. Dabei ist die angegebene Reihenfolge vorteilhaft, aber nicht zwingend. Insbesondere kann die Reihenfolge von Trägerfolie und Leiterbahn(en) vertauscht werden. Zweckmäßig ist es dabei wenn die Wärmeleitfolie mit einem Wärmeableitelement verbunden ist. Zwischen den genannten Schichten sind vorzugsweise Haft oder Klebeschichten vorgesehen.

In einer weiteren Ausführungsform ist das Wärmeableitelement aus einem Strangpressprofil hergestellt.

Diese Ausgestaltung hat den Vorteil, dass das Wärmeableitelement in größeren Stückzahlen kostengünstig herstellbar ist. Vorteilhaft ist das Strangpressprofil aus Aluminium oder einer Aluminiumlegierung hergestellt.

Jedoch sind auch Ausführungsformen denkbar, bei denen das Wärmeableitelement aus einem gut wärmeleitenden Kunststoffmaterial, beispielsweise im Spritzgießverfahren, hergestellt ist.

In einer weiteren Ausführungsform der Erfindung weist die Kontur des Wärmeableitelements einen gekrümmte Abschnitt und Kühlrippen auf, wobei die Kühlrippen dem gekrümmten Abschnitt im Wesentlichen gegenüberliegen.

Auf den gekrümmten Abschnitt kann die Trägerfolie aufgebracht werden, so dass diese im Profil gesehen ebenfalls die Form des gekrümmten Abschnitts aufweist. Dadurch kann eine Vergrößerung des beleuchteten Winkelbereichs in der Abstrahlcharakteristik des Leuchtmittels erreicht werden. Das Wärmeableitelement besteht in dieser Ausführungsform vorteilhaft aus Vollmaterial, so dass die Wärme von dem gekrümmten Abschnitt mit einem geringen thermischen Widerstand in die Kühlrippen abgeleitet werden kann.

In einer weiteren Ausführungsform ist eine ebene Trägerfolie senkrecht zu ihrer Oberfläche, die mit den Leuchtdioden bestückt ist, zu einer ins Dreidimensionale umgeformten Trägerfolie verformt.

Die Verformung kann durch Falten, Biegen, Abkanten oder ähnliche Verfahren bewirkt werden. In besonderen Ausführungsformen kann die umgeformte Trägerfolie ausschließlich Knickstellen und Biegungen aufweisen, so dass die Trägerfolie nicht verwölbt wird. In einer weiteren Ausführungsform kann die Trägerfolie gezielt verwölbt werden, indem sie z.B. unter Druck- und/oder Wärmeeinwirkung auf eine Oberfläche aufgebracht und an deren Form angepasst wird, wobei deren Form von einer Trägerfolie nicht ohne Verwölbung eingenommen werden kann. Eine solche Form kann beispielsweise eine Kalotte oder ein Ellipsoidsegment sein.

In noch einer weiteren Ausführungsform weist die Trägerfolie Schnitte auf, so dass das Umformen in eine dreidimensionale Form nicht durch die Verbindung bestimmter Stellen der Trägerfolie behindert wird.

In einer weiteren Ausführungsform weist die Trägerfolie in der ebenen Form eine Außenkontur mit Ecken auf, an die Faltlinien zur dreidimensionalen Verformung verlaufen. Vorteilhaft sind dies konvexe Ecken am Rande der Trägerfolie. Dann kann durch entsprechendes Falten ein Hohlkörper aus der Trägerfolie hergestellt werden, der nur kleine oder keine Durchbrüche auf der Oberfläche mit den Leuchtdioden aufweist, wobei sich die Leuchtdioden auf der Innenseite oder der Außenseite des Hohlkörpers befinden können. Vorteilhaft kann die Kontur der ebenen Trägerfolie so gestaltet sein, dass sie eine Abwicklung eines geometrischen Körpers oder einen Teil davon darstellt.

In einer alternativen Ausführungsform kann das Profil der Trägerfolie zu einem Kreisabschnitt, einem Abschnitt einer Ellipse oder einer Hyperbel oder einer anderen kontinuierlich verlaufenden Kurve gebogen werden. Die Trägerfolie stellt dann die eben Abwicklung der Oberfläche dar, auf die sie aufgebracht werden soll. Auch auf diese Weise kann aus der Trägerfolie ein dreidimensionales Gebilde erzeugt werden, auf dessen Innen- oder Außenseite sich die Leuchtdioden befinden. Durch eine solche Geometrie der Anordnung der Leuchtdioden kann eine bestimmte Abstrahlcharakteristik realisiert werden.

In einer weiteren Ausführungsform können zusätzlich zu der reinen Biegung auch Faltstellen in der Trägerfolie vorgesehen sein, an denen die Biegung stärker ist und auf einer geringeren Fläche vorliegt. Vorteilhaft sind dabei die Leuchtdioden auf der Außenseite des so gebildeten Körpers angebracht. Mit den durch Falten abgewinkelten Bereichen der Trägerfolie kann dann beispielsweise ein bestimmter Bereich besonders ausgeleuchtet werden. Durch Vorsehen einer Faltstelle kann auch eine Beleuchtungsrichtung in einer Abstrahlcharakteristik ausgespart werden, beispielsweise, um in dieser Richtung Blendung zu vermeiden oder einen Mast nicht unnötig zu beleuchten.

In noch einer weiteren Ausführungsform können Teile der Trägerfolie nach dem Falten übereinander verlaufen. Dabei kann vorteilhaft nur einer der übereinander verlaufenden Abschnitte der Trägerfolien mit Leuchtdioden bestückt sein. In noch einer weiteren Ausführungsform können mehrere Trägerfolien zu einem einzigen dreidimensionalen, mit Leuchtdioden bestückten Gebilde zusammengefügt werden, in dem die einzelnen Trägerfolien geeignet gefaltet und durch Anordnen von Teilen dieser Folien hinter Teilen von einer oder mehreren anderen Trägerfolien derart miteinander verwoben werden, dass der gewünschte dreidimensionale Körper entsteht. Auf diese Weise können z.B. aus Streifen der Trägerfolie ein Würfel, ein Ikosaeder oder andere geometrische Formen oder Teile davon hergestellt werden.

In einer weiteren Ausführungsform variiert die Bestückungsdichte der Leuchtdioden über die Trägerfolie hinweg. Durch dieses Merkmal kann die Abstrahlcharakteristik des erfindungsgemäßen Leuchtmittels beeinflusst werden. Dies ist insbesondere bei dreidimensional verformten Trägerfolien von Vorteil, da durch die unterschiedliche Bestückungsdichte der Leuchtdioden bestimmte Winkelbereiche der Abstrahlcharakteristik höhere oder geringere Lichtstärke aufweisen können.

In einer weiteren Ausführungsform der vorliegenden Erfindung ist die Bestückungsdichte der Leuchtdiode auf der Trägerfolie in der Mitte der Trägerfolie geringer als an wenigstens einem Rand der Trägerfolie. Mit einer solchen Art der Bestückung kann durch die größere Lichtstärke, die von dem Randbereich der Trägerfolie ausgeht, erreicht werden, dass ein weiter entfernter Bereich des zu beleuchtenden Objekts mit einer größeren Lichtstärke beleuchtet wird. Dadurch wird der Effekt der schwächeren Beleuchtung in größerem Abstand kompensiert oder zumindest teilweise aufgehoben. Der Bereich der Trägerfolie mit höherer Bestückungsdichte ist dabei vorteilhaft so ausgerichtet, dass er entferntere Bereiche beleuchtet, z.B. indem er in diese Richtung gebogen ist. Besonders bevorzugt ist eine Bestückung von zwei sich gegenüberliegenden Randbereichen einer Trägerfolie mit einer höheren Dichte an Leuchtdioden. Eine solche Bestückungsdichte eignet sich insbesondere zur Beleuchtung langgestreckter Objekte von einem Standort der Leuchte aus, der sich nicht an einem Ende des zu beleuchten den Objekts befindet, wie etwa die Beleuchtung eines Gehweges oder einer Straße durch eine Straßenleuchte, wobei die Beleuchtung von den dichter bestückten Bereichen der Trägerfolie auf die entfernteren Bereiche der Straße oder des Gehweges ausgerichtet sind.

Unter der Bestückungsdichte im Sinne der vorliegenden Erfindung wird die Anzahl von Leuchtdioden pro Fläche verstanden.

In einer weiteren Ausführungsform bestehen die Leiterbahnen aus einem druckbaren Material und sind auf eine elektrisch isolierende Oberfläche der Trägerfolie gedruckt. Durch die Druckbarkeit der Leiterbahnen können diese schnell und kostengünstig auf eine Trägerfolie aufgebracht werden. Als druckbare Materialien sind beispielsweise Silber- oder Kohlepasten sowie Leitlacke geeignet. Die Leiterbahnen können auch mit isolierenden Zwischenschichten mehrlagig übereinander angeordnet sein.

In einer weiteren Ausführungsform sind die Leuchtdioden auf der Trägerfolie oberflächenmontiert. Dies vereinfacht die Herstellung, da auf Perforierungen der Trägerfolie zum Durchstecken von Kontaktierungsbeinchen verzichtet werden kann. Zudem wird die Wärmeableitung in ein Trägerelement verbessert, da durchgesteckte und verlötete Beinchen von Leuchtdioden, die als Alternative zu einer oberflächenmontierten Ausführungsform auf der den Leuchtdioden gegenüberliegenden Seite der Trägerfolie elektrisch kontaktiert sind, eine Ausnehmung in einem Trägerelement an den Kontaktierungsstellen erfordern, um diese aufzunehmen und Kurzschlüsse zu vermeiden. Direkt unter den Leuchtdioden ist bei einer nicht oberflächenmontierten Ausführungsform der Wärmeübergang dadurch besonders schlecht. Die Leiterbahnen sind vorteilhaft auf der gleichen Seite der Trägerfolie wie die Leuchtdioden angeordnet.

In einer weiteren Ausführungsform der Erfindung sind die Leuchtdioden als Chip auf der Trägerfolie befestigt. Als Leuchtdioden werden die Elemente verstanden, die aufgrund eines elektrooptischen Halbleitereffektes elektrischen Strom in Licht umwandeln. Sie können in ein Gehäuse eingesetzt sein oder als Chips ohne Gehäuse vorliegen. Der Vorteil einer direkten Montage von Chips auf die Oberfläche der Trägerfolie ist, dass diese durch die kleineren Abmessungen des Chips gegenüber einem Gehäuse flexibler bleibt. Ein weiterer Vorteil ist, dass die volle Lichtleistung ohne Abschattung und/oder Absorption durch ein Gehäuse zur Verfügung steht. Noch ein weiterer Vorteil ist die Möglichkeit, eine sehr hohe Bestückungsdichte zu erreichen.

In einer weiteren Ausführungsform weist die Trägerfolie unter einer Leuchtdiode zumindest abschnittsweise einen Durchbruch auf, wobei der Durchbruch zumindest abschnittsweise mit einem von der Trägerfolie verschiedenen Material gefüllt ist.

In einer Ausführungsform ist das von der Trägerfolie verschiedene Material in dem Durchbruch ein Klebstoff. Die Leuchtdiode wird durch die Anordnung von Klebstoff in dem Durchbruch mechanisch besonders stabil mit der Trägerfolie, aber gegebenenfalls auch mit einem Element auf der gegenüberliegenden Seite der Trägerfolie verbunden.

Das sich durch den Durchbruch bzw. die Perforation unter der Leuchtdiode erstreckende Material ermöglicht aber insbesondere eine thermische Anbindung der Leuchtdiode an ein mit der anderen Oberfläche der Trägerfolie verbundenes Element, beispielsweise einer Schicht aus wärmeleitendem Material wie etwa Wärmeleitpaste, einer Wärmeleitfolie oder dergleichen, aber auch an ein Trägerelement oder ein Wärmeableitelement.

Insbesondere ist die Verwendung eines gut wärmeleitfähigen Klebstoffs, wie etwa einem Silberleitkleber oder einem anderen elektrisch leitfähigen Klebstoff, vorteilhaft, um die Wärmeableitung aus der Leuchtdiode erheblich zu verbessern. Dabei ist bei Verwendung von Kunststofffolie als Trägerfolie ein Teil der meist schlecht wärmeleitfähigen Trägerfolie durch ein besser wärmeleitendes Material ersetzt.

In einer weiteren Ausführungsform der Erfindung sind weiterhin die Leuchtdioden mit elektrisch leitfähigem Klebstoff an die Leiterbahnen elektrisch angeschlossen. Dies ermöglicht, weniger temperaturfeste Trägerfolien zu verwenden, da auf diese Weise die elektrische Verbindung nicht gelötet werden muss. Als elektrisch leitfähiger Klebstoff kann beispielsweise ein UV-aushärtender Klebstoff oder ein Klebstoff gewählt werden, der nach einer Aktivierung, beispielsweise durch Sauerstoff, der bei Applikation aus der Umgebungsluft verfügbar wird, oder durch Mischen mit einem Härter oder durch ultraviolettes Licht oder andere nicht thermische Härtungsmechanismen aushärtet. Alternativ kann auch ein warmhärtender Klebstoff verwendet werden, der bei Temperaturen unterhalb der Temperatur, bei der die Trägerfolie störend erweicht oder sich anderweitig störend verändert, z.B. bei weniger als 200° C, vorzugsweise bei weniger als 150° C und besonders bevorzugt bei weniger als 100° C, aushärtet.

In einer weiteren Ausführungsform weisen die Leuchtdioden ein Gehäuse auf, das mit der Trägerfolie verbunden ist. Dadurch kann die Bestückung mit herkömmlichen Bestückungsautomaten durchgeführt werden.

In einer weiteren Ausführungsform stellt die elektrische Verbindung der Leuchtdioden mit den Leiterbahnen gleichzeitig die mechanische Verbindung dar.

In einer weiteren Ausführungsform ist die Trägerfolie perforiert und an den Perforationsstellen gefaltet. Dadurch können Faltlinien in der Trägerfolie vorgegeben werden, was die Herstellung eines dreidimensionalen Körpers aus der Trägerfolie vereinfacht. Leiterbahnen zwischen Teilen der Trägerfolie, die durch die Perforation getrennt sind, verlaufen vorteilhaft zwischen den Perforationsstellen.

Dabei ist auf eine Oberfläche der Trägerfolie zumindest abschnittsweise ein Verbundmaterial so aufgebracht, dass es zumindest eine der Leuchtdioden überdeckt, wobei das Verbundmaterial ein Luminophormaterial aufweist und wobei das Verbundmaterial flexibel ist, so dass es zusammen mit der Trägerfolie verformbar ist.

Die Schicht aus dem Verbundmaterial wird vorteilhaft über den Leuchtdioden auf die Trägerfolie aufgebracht. Das Luminophormaterial wandelt Licht aus Leuchtdioden in weißes Licht um, so dass ein weiß strahlendes Leuchtmittel entsteht. Durch die Dehnbarkeit des Verbundmaterials bleiben die Flexibilität, und damit die einfache Verarbeitbarkeit und die weiteren damit verbundenen Vorteile der Trägerfolie erhalten. Als Verbundmaterial ist insbesondere ein Material, das ein Silikonelastomer enthält, geeignet. Auch die Verwendung anderer weicher oder geschäumter transparenter Kunststoffe ist möglich.

In einer weiteren Ausführungsform sind die Leuchtdioden organische Leuchtdioden. Auf diese Weise kann ein Leuchtmittel mit großflächigen Leuchtdioden erzeugt werden, bei dem ein Großteil der Trägerfolie abstrahlt. Dadurch, dass organische Leuchtdioden in dünnen Schichten hergestellt werden können, bleibt trotz der Großflächigkeit der Dioden die Flexibilität der Trägerfolie erhalten.

Eine weitere Ausgestaltung der Erfindung betrifft eine Leuchte, vorzugsweise eine Straßenleuchte, die mit einem Leuchtmittel gemäß der Erfindung versehen ist. Noch eine weitere Ausgestaltung der Erfindung betrifft einen Straßenzug, bei dem die Beleuchtungen mit Leuchtmitteln gemäß der Erfindung ausgestattet sind.

Die zuvor genannte Aufgabe wird auch durch ein Herstellungsverfahren für ein Leuchtmittel gelöst, das die folgende Schritte aufweist: Aufbringen einer elektrischen Leiterbahn auf eine elektrisch isolierende Oberfläche einer flexiblen Trägerfolie, Aufbringen mehrerer Leuchtdioden auf die Trägerfolie, elektrisches Verbinden eines elektrischen Anschlusses der Leuchtdioden mit der Leiterbahn und Aufbringen eines Verbundmaterials zumindest abschnittsweise auf eine Oberfläche der Trägerfolie so, dass es zumindest eine der Leuchtdioden überdeckt, wobei das Verbundmaterial ein Luminophormaterial aufweist und wobei das Verbundmaterial flexibel ist, sodass es zusammen mit der Trägerfolie verformbar ist.

In einer weiteren Ausführungsform des Verfahrens wird in einem weiteren Schritt die Trägerfolie in eine dreidimensionale Form gebracht.

Dies kann beispielsweise durch Falten, Abkanten, Biegen oder in einer weiteren Ausführungsform des Verfahrens durch Warmverformen in eine verwölbte Form durchgeführt werden. Vorteilhaft ist dabei die Befestigung der Leuchtdioden auf der Trägerfolie temperaturfester als die Trägerfolie, sodass die Befestigung der Leuchtdioden während des Warmumformens erhalten bleibt.

In einer weiteren Ausführungsform des Verfahrens wird die Trägerfolie in einem weiteren Schritt auf ein Wärmeableitelement aufgebracht. Das Aufbringen kann beispielsweise durch Aufkleben oder Aufspannen realisiert werden. Beim Aufspannen wird die Trägerfolie an einzelnen Stellen so befestigt, dass sich ein zwischen diesen Stellen liegender Bereich der Trägerfolie an ein Wärmeableitelement anschmiegt. In noch einer weiteren Ausführungsform des Verfahrens ist die Trägerfolie mit einer Anschlussstelle für einen Stecker versehen, wobei bei der Montage der Trägerfolie in eine Leuchte in einem weiteren Schritt die Anschlussstelle an einen Stecker angeschlossen wird.

Weitere Vorteile, Merkmale und Anwendungsmöglichkeiten der Erfindung ergeben sich sowohl aus der folgenden Beschreibung von bevorzugten Ausführungsformen, als auch den dazugehörigen Figuren. Es zeigen:
- Figur 1: einen Querschnitt durch einen Abschnitt einer Trägerfolie mit einer Leuchtdiode in einem Gehäuse auf einem Wärmeableitelement,
- Figur 2: den Querschnitt eines Strangpressprofils mit Kühlrippen, auf das eine Trägerfolie mit Leuchtdioden aufgeklebt ist,
- Figur 3: einen Querschnitt durch ein Wärmeableitelement mit einer Ausnehmung, in der eine Trägerfolie mit Leuchtdioden angeordnet ist,
- Figur 4: ein Blech mit einer Aussparung, in die eine Trägerfolie freitragend eingeklemmt ist,
- Figur 5: eine Abwicklung einer Trägerfolie mit bestückten und unbestückten Bereichen,
- Figur 6: eine Abwicklung einer Trägerfolie mit Faltlinien und
- Figur 7: Abwicklungen der Mäntel eines Kegelstumpfes bzw. eines Kegels.

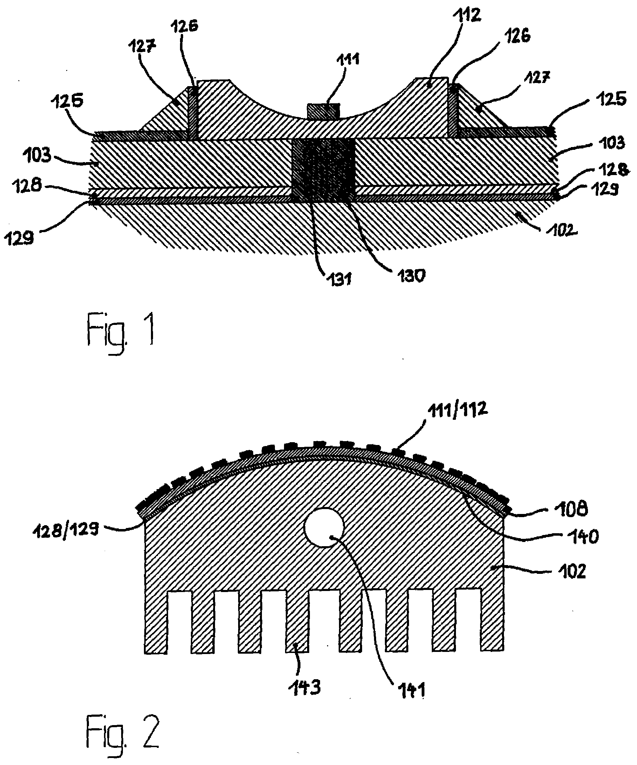

In Figur 1 ist ein Querschnitt eines Abschnitts einer Trägerfolie 103 mit einer Leuchtdiode 111, die von einem Gehäuse 112 umfasst ist, gezeigt. Auf der Trägerfolie 103 befinden sich Leiterbahnen 125, an die das Gehäuse 112 der Leuchtdiode 111 mit seinen Anschlussstellen 126 mit elektrisch leitfähigem Klebstoff 127 angeschlossen ist. Die Trägerfolie ist mit einer Wärmeleitfolie 128 versehen, die Unebenheiten auf der Oberfläche der Trägerfolie und Unebenheiten des Wärmeableitelements 102, auf das die Trägerfolie 103 aufgebracht ist, ausgleicht.

Bei der Trägerfolie 103 handelt es sich um eine flexible Leiterplatte aus einer Polyimid-Folie. Die Wärmeleitfolie wird von einer Folie auf Basis von Kapton gebildet.

Zwischen der Wärmeleitfolie 128 und dem Wärmeableitelement 102 ist eine Klebstoffschicht 129 angeordnet, mit der die Wärmeleitschicht 128 und damit die ganze Trägerfolie 103 auf das Wärmeableitelement 102 aufgeklebt ist. In der dargestellten Ausführungsform ist die Wärmeleitfolie128 selbstklebend ausgestaltet, so dass die mit den Leuchtdioden 111 bestückte Anordnung aus Trägerfolie 103 und Wärmeleitfolie 128 nach Abziehen einer Schutzschicht auf das Wärmeableitelement 102 aufgeklebt werden kann.

In einer alternativen Ausführungsform kann zwischen der Wärmeleitschicht 128 und der Trägerfolie 103 eine weitere Klebstoffschicht angeordnet sein, um die Haftung zwischen diesen Komponenten zu verbessern. Die Klebstoffschicht muss nicht durchgängig über die gesamte, von der Trägerfolie 103 bedeckte Oberfläche des Wärmeableitelements 102 aufgebracht sein, sondern kann sich auf einzelne Bereiche beschränken.

Unterhalb der Leuchtdiode 111 befindet sich in der Trägerfolie 103 ein Durchbruch 130, der mit einem Klebstoff 131 gefüllt ist. Der Klebstoff 131 erstreckt sich so durch den Durchbruch 130, dass er die Unterseite des Gehäuses 112 der Leuchtdiode 111 mit dem Wärmeableitelement 102 verbindet. Bei dem Klebstoff handelt es sich um einen gut wärmeleitenden Klebstoff, der Kupferspänen versetzt ist, d.h. auch elektrisch leitfähig ist, wodurch die Wärmeableitung von der Leuchtdiode 111 in das Wärmeableitelement 102 gegenüber der von der Trägerfolie 103 bereitgestellten thermischen Leitfähigkeit deutlich verbessert ist.

In Figur 2 ist ein Querschnitt durch ein Wärmeableitelement 102 dargestellt. Dieses weist einen kreisbogenförmigen Abschnitt 140 auf, auf dem mit einer Klebstoffschicht 129 und einer Wärmeleitschicht 128 eine Trägerfolie 103 mit Leuchtdioden 111 mit Gehäuse 112 aufgebracht ist. Die Leuchtdioden 111, 112 sind zu den Rändern des kreisbogenförmigen Abschnitts 140 hin dichter bestückt als in der Mitte desselben. Das Wärmeableitelement 102 ist als stranggepresstes Profil ausgeführt.

In der Mitte des Wärmeableitelements 102 ist eine Ausnehmung 141 angeordnet, die sich bis wenigstens zu einem Ende, vorzugsweise bis zu beiden Enden des Wärmeableitelements 102 in einer Richtung senkrecht zur Zeichnungsebene fortsetzt. Diese Ausnehmung 141 dient dazu, das Leuchtmittel einschließlich des Wärmeableitelements z.B. auf einer Stange in einer Lampe aufnehmen zu können.

Dem kreisbogenförmigen Abschnitt 140 liegen mehrere Kühlrippen 143 gegenüber, die die Oberfläche des Wärmeableitelements 102 vergrößern und so die Wärmeableitung verbessern. Das Wärmeableitelement 102 besteht in der dargestellten Ausführungsform aus Aluminium. Die Wärmeableitung kann durch das Wärmeableitelement 102 auch in Teile stattfinden, an denen das Wärmeableitelement 102 befestigt ist.

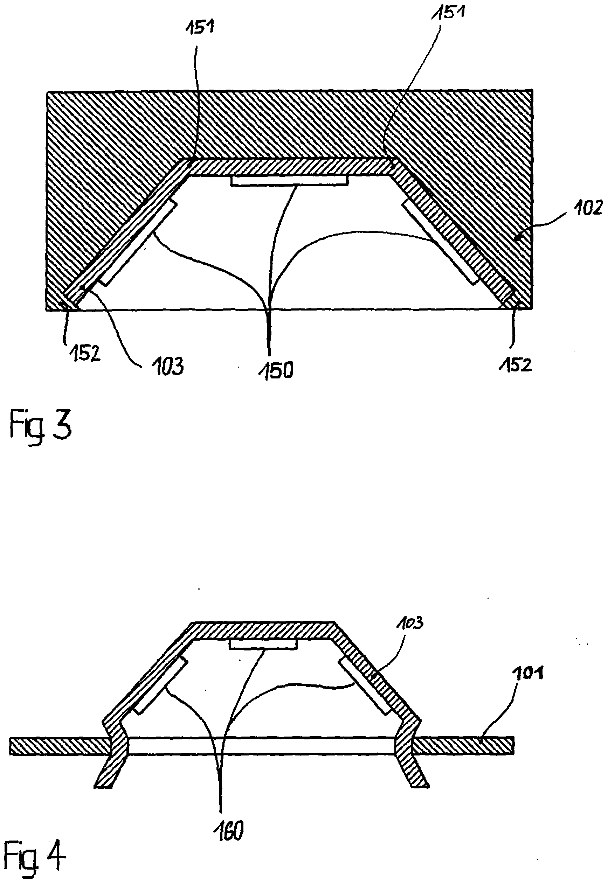

In der Figur 3 ist eine weitere Ausführungsform eines erfindungsgemäßen Leuchtmittels im Querschnitt gezeigt. Eine Trägerfolie 103 mit drei Leuchtdiodenfeldern 150, die jeweils aus mehreren organischen Leuchtdioden bestehen, ist in einer Ausnehmung eines Wärmeableitelements 102 angeordnet. Zwischen der Trägerfolie 103 und dem Wärmeableitelement 102 ist eine Wärmeleitpaste (nicht dargestellt) angeordnet.

Die Trägerfolie ist an den Faltstellen 151 aus einer ebenen Form in eine dreidimensionale Form umgeformt. Die Vorsprünge 152 an der Ausnehmung in dem Wärmeableitelement 102 halten die Trägerfolie 103 an ihrem Platz und drücken die dem Wärmeableitelement 102 zugewandte Seite der Trägerfolie 103 gegen das Wärmeableitelement 102. Auf das Verkleben der Trägerfolie 103 kann daher in dieser Ausführungsform verzichtet werden, insbesondere, wenn die Trägerfolie aus so dickem Material ausgeführt ist, dass sie eine Eigenstabilität aufweist, die eine Wellenbildung verhindert, wie etwa aus einem Aluminiumblech mit einer isolierenden Kaschierung oder Beschichtung. Durch die Vorsprünge 152 kann eine Vorspannung auf die Trägerfolie 103 aufgebracht werden, sodass diese zumindest in ihrem mittleren Bereich an das Wärmeableitelement 102 angepresst ist.

In der Figur 4 ist ein Querschnitt durch eine selbsttragende dreidimensional verformte Trägerfolie 103 mit drei Leuchtdiodenfeldern 160, die jeweils aus mehreren Leuchtdioden bestehen, dargestellt. Die dreidimensional verformte Trägerfolie 103 ist in einen Halter 101 eingeklemmt, wodurch die Trägerfolie 103 sowohl daran befestigt ist, als auch in ihrer Form gehalten wird. Dazu weist der Rand der Trägerfolie eine Sicke 106 auf, durch die die Position der Trägerfolie 103 mit Hilfe von Vorspannung der Trägerfolie 103 nach außen gegenüber dem Halter 101 fixiert ist. Die Trägerfolie 103 ist vorteilhaft aus einer ebenen Form in die gezeigte Form umgeformt. Die Trägerfolie 103 besteht vorteilhaft aus Kupfer oder Aluminium, das mit einer isolierenden Schicht wie etwa einem Lack oder einer dünnen Folie kaschiert ist, auf der im ebenen Zustand der Trägerfolie 103 Leiterbahnen aus Silberpaste aufgedruckt und diese ausgehärtet wurden. Die Leuchtdiodenfelder können in anderen Ausführungsformen auch auf der konvexen Seite der Trägerfolie angebracht sein oder durch einzelne Leuchtdioden ersetzt sein (nicht gezeigt).

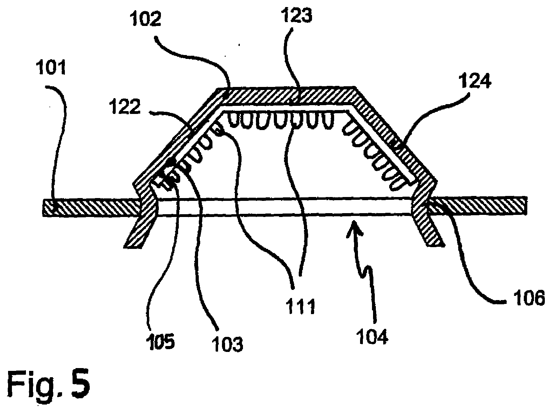

In der Figur 5 ist ein Querschnitt durch eine ähnliche Ausführungsform wie in Figur 4 gezeigt. Die Trägerfolie 103 ist dabei mehrschichtig ausgeführt und besteht aus einem Aluminium- oder Kupferblech 102 und einer Polyimidfolie mit einer Dicke von etwa 25 µm, die mit Kupfer kaschiert ist, das zur Bereitstellung der Leiterbahnen entsprechend geätzt ist. An die Leiterbahnen sind Leuchtdioden 111 in Oberflächenmontage angeschlossen. Die elektrischen Verbindungsstellen sind gleichzeitig auch die mechanische Befestigung der Leuchtdioden 111. Die Polyimidschicht 105 ist mit einer Klebstoffschicht auf das Blech 102 aufgeklebt.

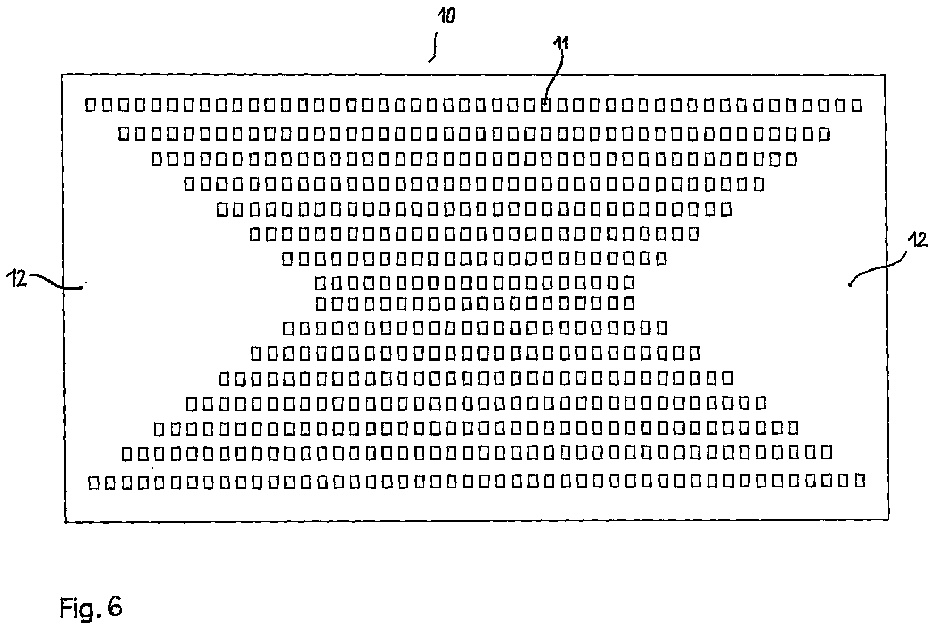

In der Figur 6 ist eine Abwicklung einer Trägerfolie gezeigt, die ungleichmäßig mit Leuchtdioden bestückt ist. In ihre dreidimensionale Form wird die Trägerfolie um die Mittelachse zwischen den langen Seiten gebogen, so dass ein Leuchtmittel in Form eines Zylindersegments entsteht. Der Querschnitt kann in einer alternativen Ausführungsform auch von einem Kreisabschnitt abweichen. Durch die dreieckigen Aussparungen 12 der Bestückung mit Leuchtdioden 11 an den kurzen Seiten der Abwicklung der Trägerfolie 10 entsteht an den Rändern in Achsrichtung des Zylindersegments eine höhere Lichtstärke. Durch die Biegung der Trägerfolie 10 wird eine erhöhte Lichtstärke in zwei unterschiedliche Richtungen erreicht. Diese liegen bei der Verwendung des Leuchtmittels in einer Straßenlaterne so, dass damit die am weitesten von dem Leuchtmittel entfernten Bereiche beleuchtet werden. Die Achse, um die die Trägerfolie 10 gebogen ist, liegt daher in einer Ebene, die quer zur Längsrichtung und senkrecht zur Oberfläche einer beleuchteten Straße oder einem Gehweg angeordnet ist.

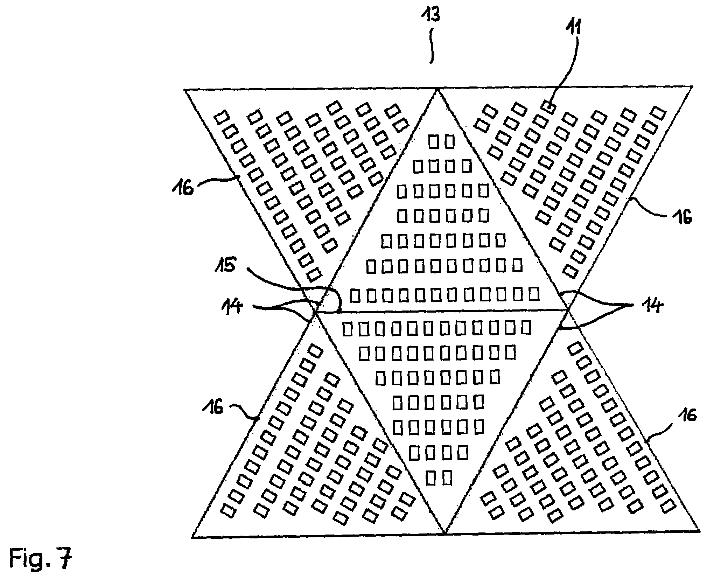

In der Figur 7 ist eine weitere Abwicklung einer Trägerfolie 13 mit Leuchtdioden 11 dargestellt. Die Trägerfolie hat die Kontur eines Rechtecks, an dessen kürzeren Seiten von den Ecken ausgehend jeweils ein Dreieck in Richtung der Mitte ausgeschnitten ist. Der Träger ist durch die Faltlinien 14 und 15 in sechs Dreiecke unterteilt. Die Faltlinien 14 erstrecken sich dabei von den im Inneren des Rechtecks liegenden Spitzen des ausgeschnittenen Dreiecks zu den Mitten der langen Seite des Rechtecks, und die Faltlinie 15 erstreckt sich von einer Spitze eines ausgeschnittenen Dreiecks zu der anderen Spitze des anderen ausgeschnittenen Dreiecks. Die Dreiecke, die durch die Unterteilung des ausgeschnittenen Rechtecks durch die Faltlinien 14 und 15 entstehen, sind gleichseitige Dreiecke. In alternativen Ausführungsformen können sie jedoch auch gleichschenklig oder unregelmäßig sein. Auf den Faltlinien 14 und 15 befinden sich keine Leuchtdioden 11.
Die Trägerfolie 13 kann durch Falten entlang der Faltlinien 14 und 15 in eine dreidimensionale Form gebracht werden. Dazu werden die außenliegenden Dreiecke um die Linie 14 in Richtung der Leuchtdioden 11 gebogen. Der Biegewinkel der vier Dreiecke um die Linie 14 kann dabei in einer Ausführungsform für alle Dreiecke gleich sein. Außerdem werden die beiden Hälften der Trägerfolie 13 um die Linie 15 gebogen. Der Biegewinkel um die Linie 15 wird dabei vorzugsweise so gewählt, dass sich die Außenkonturen 16 berühren. Auf diese Weise entsteht ein geschlossener Abschnitt des Hohlkörpers, auf dessen Innenseite die Leuchtdioden angeordnet sind. Alternativ können die Leuchtdioden auch auf den Außenseiten angeordnet sein, wozu die dreieckigen Segmente der Trägerfolie in die entgegengesetzte Richtung gebogen werden.

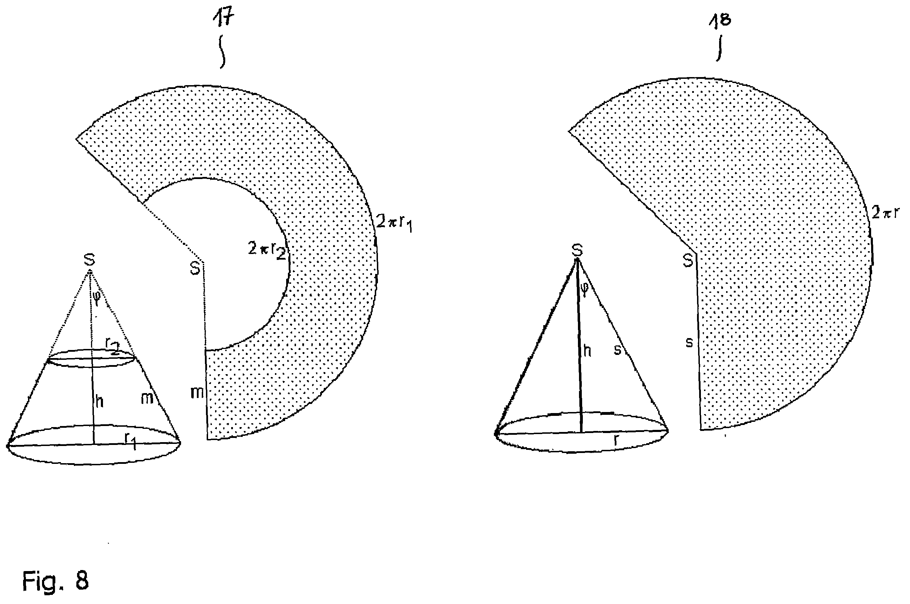

In der Figur 8 ist eine weitere mögliche Form einer Trägerfolie für ein erfindungsgemäßes Leuchtmittel dargestellt. Die Trägerfolie hat dabei die Form eines Kreisringabschnitts 17 oder eines Kreisabschnitts 18. Die Trägerfolie 17 kann zu einem Hohlkörper in Form eines Kegelstumpfes gebogen werden, und die Trägerfolie 18 kann in die Form eines Hohlkegels gebogen werden. Die Leuchtdioden können dabei im Inneren oder auf der Außenseite des so entstehenden Hohlkörpers angeordnet sein. Alternativ zu einer kontinuierlichen Biegung können die genannten Hohlkörper in einer alternativen Ausführungsform näherungsweise auch aus Flächenabschnitten, die in sich eben sind, gebildet werden. In noch einer alternativen Ausführungsform ist die Trägerfolie so gestaltet, dass sie in ihrer dreidimensionalen Form nur ein Segment eines Kegelstumpfes oder eines Kegels bildet.

### Bezugszeichenliste

- 10: Trägerfolie
- 11: Leuchtdioden
- 12: dreieckige Aussparungen
- 13: Trägerfolie
- 14: Faltlinie
- 15: Faltlinie
- 16: Außenkontur
- 17: Trägerfolie in Form eines Kreisringabschnitts
- 18: Trägerfolie in Form eines Kreisabschnitts
- 101: Halter
- 102: Wärmeableitelement
- 103: Trägerfolie
- 105: Leiterbahnen
- 106: Sicke
- 111: Leuchtdiode
- 112: Gehäuse
- 126: Anschlussstellen
- 127: elektrisch leitfähiger Klebstoff
- 128: wärmeleitfähige Folie/Wärmeleitfolie/Wärmeleitschicht
- 129: Klebstoffschicht
- 130: Durchbruch
- 131: Klebstoff
- 140: kreisbogenförmiger Abschnitt
- 141: Ausnehmung
- 143: Kühlrippen
- 150: Leuchtdiodenfelder
- 151: Faltstellen
- 152: Vorsprünge
- 160: Leuchtdiodenfelder

## Patentansprüche

1. Leuchtmittel
mit einer Mehrzahl von Leuchtdioden (11, 111), die jeweils elektrische Anschlüsse (126) aufweisen, und
mit einer flexiblen Trägerfolie (103) mit mindestens einer elektrisch isolierenden Oberfläche,
wobei die Leuchtdioden (11, 111) auf die Trägerfolie (103) aufgebracht sind,
wobei auf der elektrisch isolierenden Oberfläche der Trägerfolie (103) mindestens eine elektrische Leiterbahn (105) angeordnet ist und
wobei ein elektrischer Anschluss der Leuchtdioden (11, 111) elektrisch leitend mit der Leiterbahn (105) verbunden ist,
**dadurch gekennzeichnet, dass** auf eine Oberfläche der Trägerfolie (103) zumindest abschnittsweise ein Verbundmaterial so aufgebracht ist, dass es zumindest eine der Leuchtdioden überdeckt, wobei das Verbundmaterial ein Luminophormaterial aufweist und wobei das Verbundmaterial flexibel ist, so dass es zusammen mit der Trägerfolie verformbar ist.

2. Leuchtmittel nach Anspruch 1, **dadurch gekennzeichnet, dass** die Trägerfolie (103) unter einer Leuchtdiode (11, 111) zumindest abschnittsweise einen Durchbruch (130) aufweist, wobei der Durchbruch zumindest abschnittsweise mit einem von der Trägerfolie (103) verschiedenen Material (130) gefüllt ist.

3. Leuchtmittel nach einem der vorangehenden Ansprüche, **dadurch gekennzeichnet, dass** auf die den Leuchtdioden (11, 111) abgewandte Oberfläche der Trägerfolie (103) eine Wärmeleitpaste (128), ein Wärmeleitlack (128) oder eine Wärmeleitfolie (128) aufgebracht ist.

4. Leuchtmittel nach einem der vorangehenden Ansprüche, **dadurch gekennzeichnet, dass** die Trägerfolie (103) auf ein Wärmeableitelement (102) aufgebracht ist, das im Betrieb Wärme von den Leuchtdioden (11, 111) abführt.

5. Leuchtmittel nach Anspruch 4, **dadurch gekennzeichnet, dass** das Wärmeableitelement (102) aus einem Strangpressprofil hergestellt ist.

6. Leuchtmittel nach Anspruch 4 oder 5, **dadurch gekennzeichnet, dass** die Kontur des Wärmeableitelements (102) einen gekrümmten Abschnitt, vorzugsweise einen Kreisabschnitt (140), und Kühlrippen (143), die dem gekrümmten Abschnitt (140) im wesentlichen gegenüberliegend angeordnet sind, aufweist, wobei die Trägerfolie auf dem gekrümmten Abschnitt des Wärmeableitelements (102) angeordnet ist.

7. Leuchtmittel nach einem der Ansprüche 3 bis 5, **dadurch gekennzeichnet, dass** die Wärmeleitpaste (128), der Wärmeleitlack (128) oder die Wärmeleitfolie (128) zwischen der Trägerfolie (103) und dem Wärmeableitelement (102) angeordnet ist.

8. Leuchtmittel nach einem der vorangehenden Ansprüche, **dadurch gekennzeichnet, dass** die Bestückungsdichte der Leuchtdioden (11, 111) auf der Trägerfolie (103) variiert.

9. Leuchtmittel nach Anspruch 8, **dadurch gekennzeichnet, dass** die Bestückungsdichte der Leuchtdioden (11, 111) auf der Trägerfolie (103) in der Mitte der Trägerfolie (103) geringer ist als an wenigstens einem Rand der Trägerfolie (103).

10. Leuchtmittel nach einem der vorangehenden Ansprüche, **dadurch gekennzeichnet, dass** die Leiterbahnen (105) aus einem druckbaren Material bestehen und auf die elektrisch isolierende Oberfläche der Trägerfolie (103) gedruckt sind.

11. Leuchtmittel nach einem der vorangehenden Ansprüche, **dadurch gekennzeichnet, dass** die Leuchtdioden (11, 111) auf die Trägerfolie (103) oberflächenmontiert sind.

12. Leuchtmittel nach einem der vorangehenden Ansprüche, **dadurch gekennzeichnet, dass** die Leuchtdioden (11, 111) in Form eines Chips auf die Trägerfolie (103) aufgebracht sind.

13. Leuchte, vorzugsweise Straßenleuchte, mit einem Leuchtmittel nach einem der Ansprüche 1 bis 12.

14. Verfahren zur Herstellung eines Leuchtmittels mit den Schritten:
- Aufbringen einer elektrischen Leiterbahn (105) auf eine elektrisch isolierende Oberfläche einer flexiblen Trägerfolie (103),
- Aufbringen mehrerer Leuchtdioden (11, 111) auf die Trägerfolie (103),
- elektrisches Verbinden eines elektrischen Anschlusses der Leuchtdioden (11, 111) mit der Leiterbahn (105),
**dadurch gekennzeichnet, dass** es den weiteren Schritt aufweist
Aufbringen eines Verbundmaterials zumindest abschnittsweise auf eine Oberfläche der Trägerfolie (103) so, dass es zumindest eine der Leuchtdioden überdeckt, wobei das Verbundmaterial ein Luminophormaterial aufweist und wobei das Verbundmaterial flexibel ist, so dass es zusammen mit der Trägerfolie verformbar ist.

## Claims

1. A lamp comprising
a plurality of light-emitting diodes (11, 111) which each have electrical connections (126), and
a flexible carrier film (103) having at least one electrically insulating surface,
wherein the light-emitting diodes (11, 111) are applied to the carrier film (103),
wherein at least one electrical conductor track (105) is arranged on the electrically insulating surface of the carrier film (103), and
wherein an electrical connection of the light-emitting diodes (11, 111) is electrically conductingly connected to the conductor track (105),
**characterised in that** a composite material is at least portion-wise applied to a surface of the carrier film (103) in such a way that it covers over at least one of the light-emitting diodes wherein the composite material has a luminophore material and wherein the composite material is flexible so that it is deformable together with the carrier film.

2. A lamp according to claim 1 **characterised in that** the carrier film (103) has at least portion-wise a through opening (130) under a light-emitting diode (11, 111), wherein the through opening is at least portion-wise filled with a material (130) different from the carrier film (103).

3. A lamp according to one of the preceding claims **characterised in that** a heat-conducting paste (128), a heat-conducting lacquer (128) or a heat-conducting film (128) is applied to the surface of the carrier film (103), that faces away from the light-emitting diodes (11, 111).

4. A lamp according to one of the preceding claims **characterised in that** the carrier film (103) is applied to a heat-dissipation element (102) which in operation dissipates heat from the light-emitting diodes (11, 111).

5. A lamp according to claim 4 **characterised in that** the heat-dissipation element (102) is made from an extruded profile.

6. A lamp according to claim 4 or claim 5 **characterised in that** the contour of the heat-dissipation element (102) has a curved portion, preferably a circular portion (140), and cooling ribs (143) which are arranged substantially opposite the curved portion (140), wherein the carrier film is arranged on the curved portion of the heat-dissipation element (102).

7. A lamp according to one of claims 3 to 5 **characterised in that** the heat-conducting paste (128), the heat-conducting lacquer (128) or the heat-conducting film (128) is arranged between the carrier film (103) and the heat-dissipation element (102).

8. A lamp according to one of the preceding claims **characterised in that** the packing density of the light-emitting diodes (11, 111) on the carrier film (103) varies.

9. A lamp according to claim 8 **characterised in that** the packing density of the light-emitting diodes (11, 111) on the carrier film (103) is lower in the centre of the carrier film (103) than at at least one edge of the carrier film (103).

10. A lamp according to one of the preceding claims **characterised in that** the conductor tracks (105) comprise a printable material and are printed on to the electrically insulating surface of the carrier film (103).

11. A lamp according to one of the preceding claims **characterised in that** the light-emitting diodes (11, 111) are surface-mounted on to the carrier film (103).

12. A lamp according to one of the preceding claims **characterised in that** the light-emitting diodes (11, 111) are applied to the carrier film (103) in the form of a chip.

13. A light, preferably a street light, having a lamp according to one of claims 1 to 12.

14. A process for the production of a lamp comprising the steps:
- applying an electrical conductor track (105) to an electrically insulating surface of a flexible carrier film (103),
- applying a plurality of light-emitting diodes (11, 111) to the carrier film (103),
- electrically connecting an electrical connection of the light-emitting diodes (11, 111) to the conductor track (105),
**characterised in that** it has the further step:
applying a composite material at least portion-wise to a surface of the carrier film (103) so that it covers over at least one of the light-emitting diodes, wherein the composite material has a luminophore material and wherein the composite material is flexible so that it is deformable together with the carrier film.

## Revendications

1. Moyen d'éclairage,
avec une pluralité de diodes électroluminescentes (11, 111) qui présentent respectivement des connexions électriques (126), et
avec une feuille de support (103) flexible avec au moins une surface électriquement isolante,
les diodes électroluminescentes (11, 111) étant mises en place sur la feuille de support (103),
au moins une piste conductrice (105) électrique étant disposée sur la surface électriquement isolante de la feuille de support (103), et
une connexion électrique des diodes électroluminescentes (11, 111) étant raccordée de façon électriquement conductrice à la piste conductrice (105),
**caractérisé en ce que**, sur une surface de la feuille de support (103), il est mis en place au moins par tronçons un matériau composite de telle sorte qu'il recouvre au moins une des diodes électroluminescentes, le matériau composite présentant un matériau luminophore, et le matériau composite étant flexible de telle sorte qu'il est déformable conjointement avec la feuille de support.

2. Moyen d'éclairage selon la revendication 1, **caractérisé en ce que** la feuille de support (103) présente sous une diode électroluminescente (11, 111) au moins par tronçons une traversée (130), la traversée étant au moins par tronçons remplie d'un matériau (130) différent de la feuille de support (103).

3. Moyen d'éclairage selon l'une des revendications précédentes, **caractérisé en ce qu'**une pâte thermo-conductrice (128), une peinture thermo-conductrice (128) ou une feuille thermo-conductrice (128) est mise en place sur la surface de la feuille de support (103) qui est à l'opposé des diodes électroluminescentes (11, 111).

4. Moyen d'éclairage selon l'une des revendications précédentes, **caractérisé en ce que** la feuille de support (103) est mise en place sur un élément de dissipation de chaleur (102) qui, pendant le fonctionnement, évacue la chaleur des diodes électroluminescentes (11, 111).

5. Moyen d'éclairage selon la revendication 4, **caractérisé en ce que** l'élément de dissipation de chaleur (102) est fabriqué à partir d'un profil extrudé.

6. Moyen d'éclairage selon la revendication 4 ou 5, **caractérisé en ce que** le contour de l'élément de dissipation de chaleur (102) présente un tronçon courbe, de préférence un tronçon de cercle (140), et des ailettes de refroidissement (143) qui sont disposées essentiellement en face du tronçon courbe (140), la feuille de support étant disposée sur le tronçon courbe de l'élément de dissipation de chaleur (102).

7. Moyen d'éclairage selon l'une des revendications 3 à 5, **caractérisé en ce que** la pâte thermo-conductrice (128), la peinture thermo-conductrice (128) ou la feuille thermo-conductrice (128) est disposée entre la feuille de support (103) et l'élément de dissipation de chaleur (102).

8. Moyen d'éclairage selon l'une des revendications précédentes, **caractérisé en ce que** la densité en composants diodes électroluminescentes (11, 111) sur la feuille de support (103) varie.

9. Moyen d'éclairage selon la revendication 8, **caractérisé en ce que** la densité en composants diodes électroluminescentes (11, 111) sur la feuille de support (103) est plus faible au milieu de la feuille de support (103) que sur au moins un bord de la feuille de support (103).

10. Moyen d'éclairage selon l'une des revendications précédentes, **caractérisé en ce que** les pistes conductrices (105) sont composées d'un matériau pouvant être imprimé et sont imprimées sur la surface électriquement isolante de la feuille de support (103).

11. Moyen d'éclairage selon l'une des revendications précédentes, **caractérisé en ce que** les diodes électroluminescentes (11, 111) sont montées en surface sur la feuille de support (103).

12. Moyen d'éclairage selon l'une des revendications précédentes, **caractérisé en ce que** les diodes électroluminescentes (11, 111) sont mises en place sur la feuille de support (103) sous la forme d'une puce.

13. Luminaire, de préférence luminaire routier, avec un moyen d'éclairage selon l'une des revendications 1 à 12.

14. Procédé de fabrication d'un moyen d'éclairage, présentant les étapes suivantes :
- mise en place d'une piste conductrice (105) électrique sur une surface électriquement isolante d'une feuille de support (103) flexible,
- mise en place de plusieurs diodes électroluminescentes (11, 111) sur la feuille de support (103),
- raccordement électrique d'une connexion électrique des diodes électroluminescentes (11, 111) à la piste conductrice (105),
**caractérisé en ce qu'**il présente l'étape supplémentaire suivante :
mise en place d'un matériau composite au moins par tronçons sur une surface de la feuille de support (103) de telle sorte qu'il recouvre au moins une des diodes électroluminescentes, le matériau composite présentant un matériau luminophore, et le matériau composite étant flexible de telle sorte qu'il est déformable conjointement avec la feuille de support.
